# EUROPÄISCHE PATENTANMELDUNG

(11) **EP 0 586 841 A1**
(43) Veröffentlichungstag der Anmeldung: **16.03.1994**
(21) Anmeldenummer: 93111518.2
(22) Anmeldetag: 19.07.1993
(51) Int. Cl.: H05K 13/00, H01R 9/05

(54) **Printplatte und Montagemodul für einen Anschluss abgeschirmter Leiter und Verteilersysteme im Schwachstrom-Anlagebau**

(30) Priorität: 30.07.1992 CH 2406/92; 30.07.1992 CH 2407/92
(71) Anmelder: Reichle + De-Massari AG Elektro-Ingenieure, 8620 Wetzikon (CH)
(72) Erfinder: Reichle, Hans, CH-8620 Wetzikon (CH)
(74) Vertreter: Petschner, Goetz

(57) **Zusammenfassung**

Die Printplatte ist gekennzeichnet durch eine mehrfach-modulare Anordnung von modularen Anschluss- und Schaltungsmitteln (2,3) nebeneinander, wobei die Printplatte (1) jeweils zwischen benachbarten Modulen von Anschluss- und Schaltungsmitteln (2,3) eine Sollbruchstelle (4) aufweist zur Herstellung von Einzel-Modul-Printplatten durch Abbrechen.

Dies gestattet nun, mehrfach-modulare Printplatten mit beliebiger Anzahl Module aufzubauen, die dann geeignet sind, davon einfach-modulare oder mehrfach-modulare Teilplatten geringerer Modulanzahl durch einfaches Brechen zu gewinnen, was sowohl Fabrikation als auch Lagerhaltung wesentlich vereinfacht.

## Beschreibung

Die vorliegende Erfindung betrifft eine Printplatte.

In vielen Bereichen der Installationstechnik, insbesondere bei Schwachstromanlagen für Telefonie und Datenübertragung finden Printplatten immer häufiger Anwendung.

Problematisch ist hierbei allerdings, dass ein Bedarf an modularen wie auch mehrfach-modularen Printplatten mit unterschiedlicher Anzahl von Modulen besteht und der Aufbau der betreffenden Anlagen ständigen Aenderungen unterworfen ist, die den Einsatz weiterer oder weniger Printplatten der vorgegebenen Art verlangen.

Dies alles bedarf einer grossen Anzahl modularer Printplatten der gleichen Bestückung pro Anlage in der Lagerhaltung, was aufwendig und teuer ist.

Aufgabe der vorliegenden Erfindung ist deshalb die Schaffung einer Printplatte, welche den gestellten Anforderungen nach Mehrfach- resp. Einfach-Modulität gerecht wird.

Dies wird erfindungsgemäss zunächst erreicht durch eine mehrfach-modulare Anordnung von modularen Anschluss- und Schaltungsmitteln nebeneinander, wobei die Printplatte jeweils zwischen benachbarten Modulen von Anschluss- und Schaltungsmitteln eine Sollbruchstelle aufweist zur Herstellung von Einzel-Modul-Printplatten durch Abbrechen.

Durch diese Massnahmen ist es nunmehr möglich, mehrfachmodulare Printplatten mit beliebiger Anzahl Module aufzubauen, die dann geeignet sind, davon einfach-modulare oder mehrfach-modulare Teilplatten geringerer Modulanzahl durch einfaches Brechen zu gewinnen, was sowohl Fabrikation als auch Lagerhaltung wesentlich vereinfacht.

Sind die Printplatten für den Anschluss elektrischer Leiter, die gegen störende äussere elektrische Felder durch eine sehr gut leitende metallische Umhüllung abgeschirmt sind, wird eine bevorzugte Ausgestaltung der erfindungsgemässen Printplatte erreicht durch eine, sich über die ganze Länge der Printplatte erstreckende metallische Erdungsplatte, welche jeweils in der Erstreckung der Sollbruchstellen der Printplatte eine Sollbruchstelle aufweist zur gemeinsamen Vereinzelung von Printplatte und Erdungsplatte durch Abbrechen.

Demgemäss betrifft die vorliegende Erfindung weiter ein Montagemodul für eine solche Printplatte zum Anschluss abgeschirmter Leiter für Verteiler und Verteilersysteme im Schwachstrom-Anlagebau.

In der Telefonie oder anderen Signal-Uebertragungsbereichen sind elektrische Leiter, die gegen störende äussere elektrische Felder durch eine sehr gut leitende metallische Umhüllung abgeschirmt sind, unerlässlich. Problematisch ist dabei aber deren Verlegung im Anschluss-System, wie Printplatte u. dgl., insbesondere bezüglich einer HF-mässig optimalen Erdung der Abschirmung im Leiteranschlussbereich.

Ein Montagemodul der vorgenannten Art, das sich überall und bei jedem System zum Anschluss abgeschirmter Leiter einsetzen lässt und eine optimale HF-Erdungs-Verbindung der Leiter gewährleistet, wird nun ermöglicht durch eine, mit einem Anschluss-System, wie Printplatte u. dgl. fest verbindbare metallische Erdungsplatte, auf welcher sich mindestens eine, zum lösbaren Umschliessen mindestens eines Leiters bestimmte metallische, einen etwa halbschalenförmigen Leiter-Aufnahmebereich aufweisende Feder-Klammer leitend abstützt.

Hierbei ist es erfindungswesentlich, dass die metallische Erdungsplatte als Mehrfach-Modul ausgebildet ist und nebeneinander angeordnet eine Mehrzahl Feder-Klammern aufweist, wobei die Erdungsplatte jeweils zwischen zwei benachbarten Feder-Klammern eine Sollbruchstelle aufweist zur Herstellung von Einzel-Modulen durch Abbrechen.

Ansich könnte die Feder-Klammer ein auf die Erdungsplatte aufgenieteter Federarm sein, vorzugsweise ist aber die Feder-Klammer U-förmig. Dies gestattet eine bevorzugte Ausgestaltung derart, dass die Feder-Klammer übereinander mindestens zwei Leiter-Aufnahmebereiche aufweist zur Aufnahme von Leiter mit unterschiedlichem Durchmesser.

Erfindungsgemäss kann ferner die Feder-Klammer gleichzeitig der Zugentlastung dienen oder die Erdungsplatte kann Schlitze zur durchsteckbaren Aufnahme eines Kabelbinders aufweisen.

Eine beispielsweise Ausführungsform des Erfindungsgegenstandes ist nachfolgend anhand der Zeichnung näher erläutert. Es zeigen:
- Fig. 1: eine erfindungsgemässe Printplatte in schaubildartiger Darstellung; und
- Fig. 2: ein erfindungsgemässes Montagemodul in schaubildartiger Darstellung.

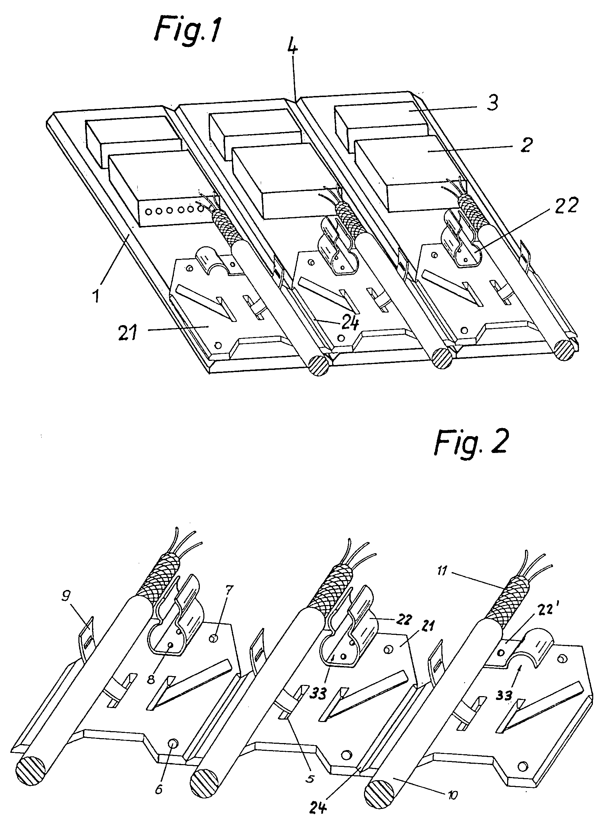

Die erfindungsgemässe Printplatte 1 gemäss Fig. 1 ist hier mehr-modular mit nebeneinander angeordneten Verbindungsmodulen aus u.a. Steckmitteln 3 und Aderanschlussmitteln 2 o. dgl. ausgebildet und weist innerhalb des Verbindungsmoduls eine hier nicht näher gezeigte, anwendungskonforme gedruckte Schaltung auf.

Erfindungsgemäss weist diese mehrfachmodulare Printplatte 1 zwischen den Modulen 2,3 und in vorgegebenen Abständen parallele Rillungen o. dgl. auf, welche Sollbruchstellen 4 zur Herstellung von Einzel-Modulen durch Abbrechen bilden.

Sind die Printplatten für den Anschluss elektrischer Leiter, die gegen störende äussere elektrische Felder durch eine sehr gut leitende metallische Umhüllung abgeschirmt sind, wird eine, sich über die ganze Länge der Printplatte 1 erstreckende metallische Erdungsplatte 21 aufgebracht, welche jeweils in der Erstreckung der Sollbruchstellen 4 der Printplatte 1 eine Sollbruchstelle 24 aufweist zur gemeinsamen Vereinzelung von Printplatte und Erdungsplatte durch Abbrechen.

Ein solches Montagemodul ist mehr im Einzelnen nachfolgend anhand Fig. 2 beschrieben.

Das Montagemodul gemäss Fig. 2 für den Anschluss des abgeschirmten Leiters 10 mit einem abgemantelten Leiterbereich 11 umfasst hier die mehrfachmodulare metallische Erdungsplatte 21, welche sich mit irgend einem Anschluss-System, hier Printplatte 1 (Fig. 1) fest verbinden lässt, etwa durch Verkleben oder, durch Bohrungen 7 hindurch, durch Verschrauben oder Vernieten.

Weitere Bohrungen 6 können dem Erdanschluss durch Einlöten eines Erdungsleiters dienen.

Die mehrfachmodulare Erdungsplatte 21 weist in vorgegebenen Abständen parallele Rillungen o. dgl. auf, welche Sollbruchstellen 24 zur Herstellung von Einzel-Modulen durch Abbrechen bilden.

Jedes so markierte Einzelmodul der Erdungsplatte 21 trägt eine, vorzugsweise durch Nietung 8 o. dgl. aufgebrachte metallische Feder-Klammer 22 resp. 22' mit einem etwa halbschalenförmigen Leiter-Aufnahmebereich 23, mit welchem die Feder-Klammer 22 resp. 22' den abgemantelten Leiterbereich 11 lösbar wenigstens teilweise umschliesst und so eine optimale HF-Erdungs-Verbindung zwischen Leiter und Erdungsplatte herstellt.

Wie ohne weiteres erkennbar, ist eine Trennung der Verbindung ohne Probleme und jederzeit möglich.

Je nach Federspannung kann die Feder-Klammer 22 resp. 22' gleichzeitig der Zugentlastung dienen, oder aber die Erdungsplatte 21 kann Schlitze 5 zur durchsteckbaren Aufnahme eines Kabelbinders 9 aufweisen.

Die Feder-Klammer kann als Zungenfeder 22' ausgebildet sein oder eine U-förmige Feder-Klammer 22 sein mit vorzugsweise zwei Leiter-Aufnahmebereichen übereinander zur Aufnahme von Leiter mit unterschiedlichem Durchmesser.

Diese Ausgestaltung des Montagemoduls, das vorzugsweise als Mehrfach-Modul hergestellt wird und dann beliebig verringert bzw. vereinzelt werden kann, gestattet eine unbeschränkte Anwendung in allen Bereichen, wo abgeschirmte Leiter anzuschliessen sind, wobei eine HF-mässig optimale Erdung gewährleistet ist.

Der Aufbau eines Printplatten-Moduls ist ansich völlig frei, ohne dabei den Rahmen des Erfindungsgedankens zu verlassen. Wesentlich ist der mehrfachmodule Aufbau der Printplatte etwa mit der maximalen Anzahl von nebeneinanderliegenden Modulen einer Anwendung, welche Printplatte sich dann nach Bedarf vereinzeln lässt, wofür lediglich ein Abbrechen entlang der Sollbruchstelle erforderlich ist.

Es wird Schutzanspruch wie folgt erhoben:

## Patentansprüche

1. Printplatte, gekennzeichnet durch eine mehrfach-modulare Anordnung von modularen Anschluss- und Schaltungsmitteln (2,3) nebeneinander, wobei die Printplatte (1) jeweils zwischen benachbarten Modulen von Anschluss- und Schaltungsmitteln (2,3) eine Sollbruchstelle (4) aufweist zur Herstellung von Einzel-Modul-Printplatten durch Abbrechen.

2. Printplatte nach Anspruch 1 für den Anschluss abgeschirmter Leiter, gekennzeichnet durch eine, sich über die ganze Länge der Printplatte (1) erstreckende metallische Erdungsplatte (21), welche jeweils in der Erstreckung der Sollbruchstellen (4) der Printplatte (1) eine Sollbruchstelle (24) aufweist zur gemeinsamen Vereinzelung von Printplatte und Erdungsplatte durch Abbrechen.

3. Montagemodul für eine Printplatte nach den Ansprüchen 1 und 2, zum Anschluss abgeschirmter Leiter für Verteiler und Verteilersysteme im Schwachstrom-Anlagebau, gekennzeichnet durch eine, mit der Printplatte fest verbindbare metallische Erdungsplatte (1), auf welcher sich mindestens eine, zum lösbaren Umschliessen mindestens eines Leiters bestimmte metallische, einen etwa halbschalenförmigen Leiter-Aufnahmebereich (3) aufweisende Feder-Klammer (2,2') leitend abstützt.

4. Montagemodul nach Anspruch 3, dadurch gekennzeichnet, dass die metallische Erdungsplatte (1) als Mehrfach-Modul ausgebildet ist und nebeneinander angeordnet eine Mehrzahl Feder-Klammern (2) aufweist, wobei die Erdungsplatte (1) jeweils zwischen zwei benachbarten Feder-Klammern (2) eine Sollbruchstelle (4) aufweist zur Herstellung von Einzel-Modulen durch Abbrechen.

5. Montagemodul nach Anspruch 3, dadurch gekennzeichnet, dass die Feder-Klammer (2) U-förmig ist.

6. Montagemodul nach Anspruch 5, dadurch gekennzeichnet, dass die Feder-Klammer (2) übereinander mindestens zwei Leiter-Aufnahmebereiche (3) aufweist zur Aufnahme von Leiter mit unterschiedlichem Durchmesser.

7. Montagemodul nach Anspruch 3, dadurch gekennzeichnet, dass die Feder-Klammer (2) gleichzeitig der Zugentlastung dient.

8. Montagemodul nach Anspruch 3, dadurch gekennzeichnet, dass die Erdungsplatte (1) Schlitze (5) zur durchsteckbaren Aufnahme eines Kabelbinders (9) aufweist.
